# EUROPEAN PATENT APPLICATION

(11) **EP 4 683 223 A1**
(43) Date of publication of application: **21.01.2026**
(21) Application number: 23928102.5
(22) Date of filing: 24.03.2023
(51) Int. Cl.: H03H 9/15

(54) **ELASTIC WAVE DEVICE, FILTER AND MULTIPLEXER**

(30) Priority: 17.03.2023 CN 202310265485
(71) Applicant: Maxscend Microelectronics Company Limited, Wuxi, Jiangsu 214000 (CN)
(72) Inventor: SONG, Chongxi, Wuxi, Jiangsu 214000 (CN); YAO, Yuan, Wuxi, Jiangsu 214000 (CN); YAO, Yanlong, Wuxi, Jiangsu 214000 (CN); DING, Yi, Wuxi, Jiangsu 214000 (CN); LONG, Zheng, Wuxi, Jiangsu 214000 (CN)
(74) Representative: Murgitroyd & Company
(86) International application number: PCT/CN2023/083723
(87) International publication number: WO 2024/192790

(57) **Abstract**

The present application discloses an elastic wave device, a filter, and a multiplexer, which relate to the field of integrated circuit technologies. The elastic wave device includes: a substrate, a piezoelectric layer arranged on the substrate, and an IDT electrode formed on the piezoelectric layer. Euler angles of the substrate are (-45°±10°, -36°±10°, -45°±10°), or (-45°±10°, -36°+10°, -225°±10°). Euler angles of the piezoelectric layer are (0°±10°, 130°±5°, 0°±10°), or (0°±10°, 140°±5°, 0°±10°). This configuration addresses the problem that parasitic acoustic modes generated in the conventional technologies affect an electrical performance of a device, thereby achieving the effect of suppressing parasitic acoustic modes and improving electrical performance through a combination of the Euler angles of the substrate and the piezoelectric layer.

## Description

### TECHNICAL FIELD

The present invention relates to an elastic wave device, a filter, and a multiplexer, belonging to the field of integrated circuit chip technologies.

### BACKGROUND

In an electro-acoustic resonator, due to the piezoelectric effect, an electrode structure combined with a piezoelectric material converts between electromagnetic signals and acoustic RF signals.

However, in practice, in addition to generating desired acoustic modes, the electrode structure may also excite parasitic acoustic modes, which can degrade the performance of a corresponding filter.

### SUMMARY

The present invention aims to provide an elastic wave device, a filter, and a multiplexer, so as to address the problems existing in the conventional technologies.

To achieve the above objectives, the present invention provides the following technical solutions:
In a first aspect, an elastic wave device is provided. The elastic wave device includes:
a substrate;
a piezoelectric layer arranged on the substrate and an IDT electrode formed on the piezoelectric layer;
where Euler angles of the substrate are (-45°±10°, -36°±10°, -45°±10°), or (-45°±10°, -36°±10°, -225°±10°); and
Euler angles of the piezoelectric layer are (0°±10°, 130°±5°, 0°±10°), or (0°±10°, 140°±5°, 0°±10°).

Optionally, the Euler angles of the substrate are (-45°±5°, -36°±5°, -45°±5°), or (-45°±5°, -36°±5°, -225°±5°).

Optionally, the Euler angles of the piezoelectric layer are (0°±5°, 130°±4°, 0°±5°), or (0°±5°, 140°±3°, 0°±5°).

Optionally, the substrate includes silicon, and the piezoelectric layer includes at least one of LiTaO₃, LiNbO₃, ZnO, AlN, and PZT.

Optionally, an intermediate layer is arranged between the substrate and the piezoelectric layer, where the intermediate layer includes:
a high-acoustic-velocity film, arranged on the substrate, where an acoustic velocity of a bulk wave propagating in the high-acoustic-velocity film is higher than an acoustic velocity of an elastic wave propagating in the piezoelectric layer; and
a low-acoustic-velocity film, arranged on the high-acoustic-velocity film, where an acoustic velocity of a bulk wave propagating in the low-acoustic-velocity film is lower than the acoustic velocity of the elastic wave propagating in the piezoelectric layer.

Optionally, the substrate is a high-acoustic-velocity substrate with a high-acoustic-velocity film arranged on an upper layer of the substrate; and a low-acoustic-velocity film is arranged between the high-acoustic-velocity substrate and the piezoelectric layer;
where an acoustic velocity of a bulk wave propagating in the high-acoustic-velocity film is higher than an acoustic velocity of an elastic wave propagating in the piezoelectric layer, and an acoustic velocity of a bulk wave propagating in the low-acoustic-velocity film is lower than the acoustic velocity of the elastic wave propagating in the piezoelectric layer.

Optionally, a film thickness of the piezoelectric layer is greater than 0.1 λ, where λ is a wavelength determined based on a period of an electrode finger of the IDT electrode.

Optionally, the piezoelectric layer is LiTaO3, where a cutting angle of the LiTaO3 is 30° or more and 60° or less.

In a second aspect, a filter is provided. The filter includes the elastic wave device described in the first aspect.

In a third aspect, a multiplexer is provided. The multiplexer includes the elastic wave device described in the first aspect.

By providing the elastic wave device, which includes: the substrate 110, the piezoelectric layer 120 over the substrate 110, and the IDT electrode 130 formed on the piezoelectric layer 120. The Euler angles of the substrate 110 are (0°±10°, ±90°±10°, ±45°±10°); The Euler angles of the piezoelectric layer 120 is (0°±10°, 120°±5°, 0°±10°), or (0°±10°, 130°±5°, 0°±10°), or (0°±10°, 140°±5°, 0°±10°). The problem that a parasitic acoustic mode generated in the conventional technologies affect an electrical performance of a device is solved. The effect of suppressing the parasitic acoustic mode and improving the electrical performance may be achieved by a combination of the Euler angles of the substrate and the piezoelectric layer.

The foregoing description is only an overview of the technical solutions of the present invention. To facilitate a clearer understanding of the technical means of the present invention and enable implementation according to the content of the specification, preferred embodiments of the present invention are described in detail below with reference to the accompanying drawings.

### BRIEF DESCRIPTION OF THE DRAWINGS

FIG. 1 is a possible cross-sectional view of an elastic wave device according to an embodiment of the present invention.
FIG. 2 is a possible measured result diagram of an elastic wave device according to an embodiment of the present invention.
FIG. 3A is a possible measured result diagram of a module incorporating the elastic wave device according to an embodiment of the present invention.
FIG. 3B is a possible measured diagram after amplifying a specified frequency band in the measured result diagram shown in FIG. 3A according to an embodiment of the present invention.
FIG. 4 is another possible cross-sectional view of an elastic wave device according to an embodiment of the present invention.
FIG. 5 is yet another possible cross-sectional view of an elastic wave device according to an embodiment of the present invention.
FIG. 6 is a possible schematic diagram of an IDT electrode according to an embodiment of the present invention.

### DETAILED DESCRIPTION OF THE EMBODIMENTS

The technical solutions of the present invention will be described clearly and completely below with reference to the accompanying drawings. Obviously, the described embodiments are merely some, but not all embodiments of the present invention. Based on the embodiments of the present invention, all other embodiments obtained by those skilled in the art without creative efforts shall fall within the protection scope of the present invention.

In the description of the present invention, it should be noted that the orientation or positional relationships indicated by the terms "center", "upper", "lower", "left", "right", "vertical", "horizontal", "inner", "outer", and the like are based on the orientation or positional relationships shown in the drawings. These terms are used only for the convenience of describing the present invention and simplifying the description, and do not indicate or imply that the referred device or element must have a specific orientation, be constructed and operated in a specific orientation, and therefore should not be construed as a limitation of the present invention. In addition, the terms "first", "second", "third" are used for descriptive purposes only and should not be construed as indicating or implying relative importance.

In the description of the present invention, it should be noted that, unless expressly specified and defined otherwise, the terms "mounted", "connected", "connection" should be interpreted broadly. For example, it may be a fixed connection, a detachable connection, or an integral connection; it may be a mechanical connection or an electrical connection; it may be a direct connection or an indirect connection through an intermediate medium, or may be an internal communication between two components. For those skilled in the art, the specific meanings of the above terms in the present invention may be understood according to specific situations.

In addition, the technical features involved in different embodiments of the present invention described below may be combined with each other as long as they do not conflict with each other.

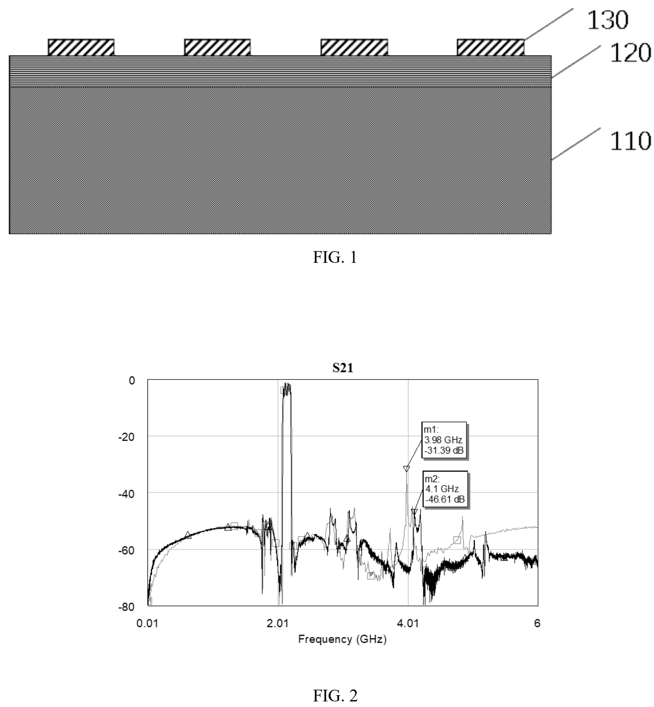

Please refer to FIG. 1, which shows a possible cross-sectional view of an elastic wave device according to an embodiment of the present invention. As shown in FIG. 1, the elastic wave device includes:
a substrate 110;
a piezoelectric layer 120 arranged on the substrate 110 and an IDT electrode 130 formed on the piezoelectric layer120;
where Euler angles of the substrate 110 are (-45°±10°, -36°±10°, -45°±10°), or (-45°±10°, -36°±10°, -225°±10°); and
Euler angles of the piezoelectric layer 120 are (0°±10°, 130°±5°, 0°±10°), or (0°±10°, 140°±5°, 0°±10°).

Optionally, the Euler angles of the substrate 110 are (-45°±5°, -36°±5°, -45°±5°), or (-45°±5°, -36°±5°, -225°±5°).

Optionally, the Euler angles of the piezoelectric layer 120 are (0°±5°, 130°±4°, 0°±5°), or (0°±5°, 140°±3°, 0°±5°).

In a possible embodiment, the Euler angles of the substrate 110 are (-45°, -36.3°, -45°), or (-45°, -36.3°, -225°). The Euler angles of the piezoelectric layer 120 are (0°, 132°, 0°), or (0°, 140°, 0°).

In a possible embodiment, please refer to FIG. 2, where the gray curve represents the measured data of an elastic wave device according to in the existing solution, and the black curve represents the measured data of the elastic wave device described in the above embodiment. As can be seen from FIG. 2, the present application, through the combination of Euler angles of the substrate and the piezoelectric layer, effectively suppresses high-frequency spurious waves, i.e., interfering parasitic acoustic modes, within a frequency range of 3.5 GHz to 5 GHz. Specifically, near 4 GHz, the interference from high-frequency spurious wave can be suppressed from -31.39 dB to -46.61 dB, achieving a reduction of nearly 15 dB.

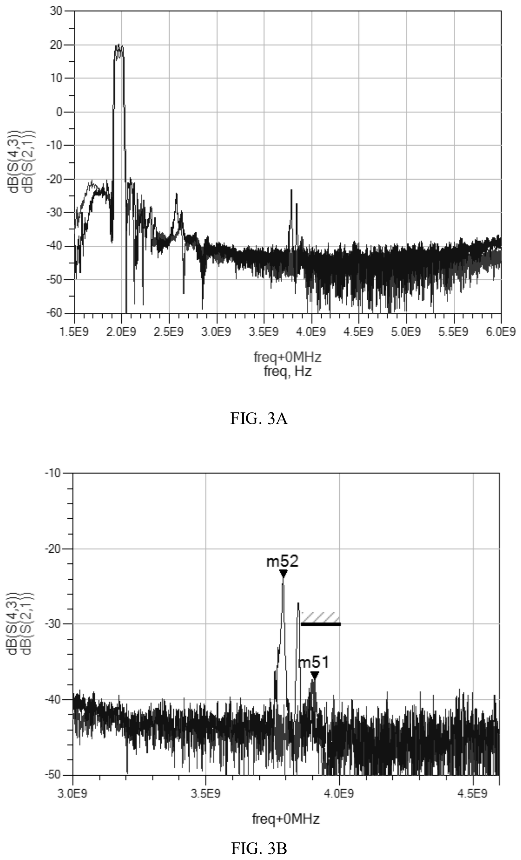

Furthermore, when the elastic wave device described above is assembled into a module, please refer to FIG. 3A, which illustrates a possible measured result diagram. As shown in FIG. 3A, the high-frequency spurious waves, i.e., interfering parasitic acoustic modes, can be effectively suppressed within the frequency range of 3.5 GHz to 5 GHz. Additionally, please refer to FIG. 3B, which shows an enlarged view of the measured data in the 3 GHz to 4.5 GHz range from FIG. 3A. It can be seen from FIG. 3B that the high-frequency spurious waves, particularly those in the 3.7 GHz to 3.9 GHz range, are effectively suppressed, achieving the effect of inhibiting the high-frequency parasitic acoustic modes. In practical implementations, the high-frequency bands that can be suppressed may vary due to factors such as the material and manufacturing process of the elastic wave device, and this application does not limit this.

Optionally, the substrate 110 includes silicon, and the piezoelectric layer 120 includes at least one of LiTaO₃, LiNbO₃, ZnO, AlN, and PZT. In practical implementation, a film thickness of the piezoelectric layer 120 is greater than 0.1 λ, where λ is a wavelength determined based on a period of an electrode finger of the IDT electrode 130.

Optionally, when the piezoelectric layer 120 is LiTaO₃, a cut angle of the LiTaO₃ is 30° or more and 60° or less.

The substrate 110 may be formed from at least one of silicon material, sapphire material, or diamond material. A thickness of the substrate 110 may be 5 µm or more, or twice a wavelength of a surface elastic wave or more.

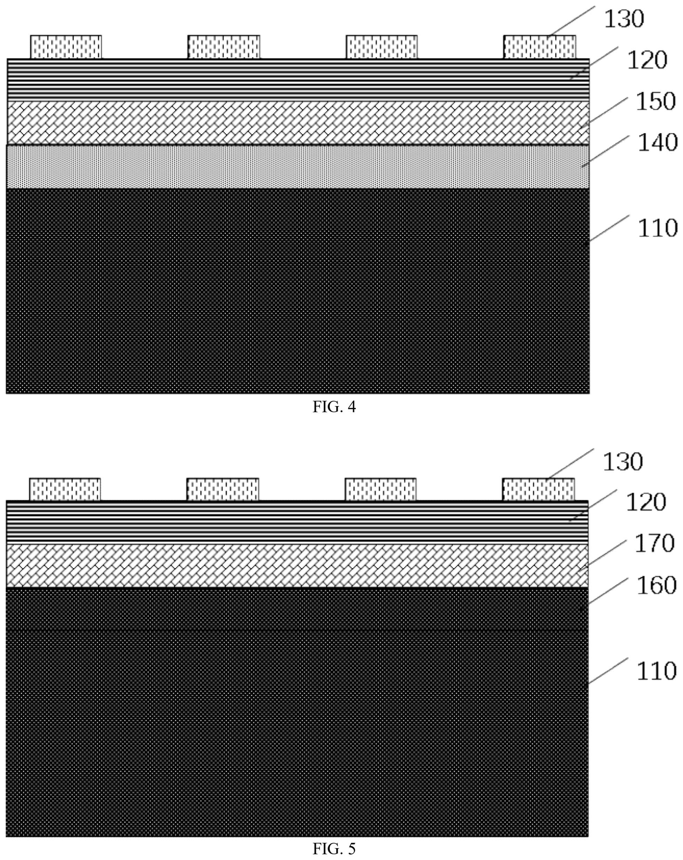

Optionally, an intermediate layer is arranged between the substrate 110 and the piezoelectric layer 120. Please refer to FIG. 4, the intermediate layer includes:
a high-acoustic-velocity film, arranged on the substrate 110, where an acoustic velocity of a bulk wave propagating in the high-acoustic-velocity film is higher than an acoustic velocity of an elastic wave propagating in the piezoelectric layer 120. The high-acoustic-velocity film 121 may be composed of one or more materials selected from aluminum oxide, silicon carbide, silicon nitride, silicon oxynitride, silicon, polysilicon, sapphire, and diamond.
a low-acoustic-velocity film, arranged on the high-acoustic-velocity film, where an acoustic velocity of a bulk wave propagating in the low-acoustic-velocity film is lower than the acoustic velocity of the elastic wave propagating in the piezoelectric layer 120. The low-acoustic-velocity film 122 may be composed of one or more materials selected from silicon oxide, aluminum nitride, glass, silicon oxynitride, tantalum oxide, or compounds of silicon oxide with added fluorine, carbon, or boron.

Optionally, please refer to FIG. 5, the substrate 110 is a high-acoustic-velocity substrate 110 with a high-acoustic-velocity film 160 arranged on its upper layer. A low-acoustic-velocity film 170 is arranged between the high-acoustic-velocity substrate 110 and the piezoelectric layer 120.

An acoustic velocity of a bulk wave propagating in the high-acoustic-velocity film 160 is higher than the acoustic velocity of the elastic wave propagating in the piezoelectric layer 120, and an acoustic velocity of a bulk wave propagating in the low-acoustic-velocity film 170 is lower than the acoustic velocity of the elastic wave propagating in the piezoelectric layer 120.

The specific configurations of the high-acoustic-velocity film and the low-acoustic-velocity film in this embodiment are similar to those in the embodiment illustrated in FIG. 4, and will not be repeated here.

The IDT electrode 130 may be composed of one or more materials selected from Ni, Mo, Fe, Cu, W, Ag, Ta, Au, and Pt. The IDT electrode 130 includes an interdigital transducer, which includes: a first busbar, and first electrode fingers and first dummy electrode fingers alternately arranged and connected to the first busbar; a second busbar, and second electrode fingers and second dummy electrode fingers alternately arranged and connected to the second busbar. The first electrode fingers and the second dummy electrode fingers are arranged opposite to each other, with a first gap between the first electrode fingers and the second dummy electrode fingers. The second electrode fingers and the first dummy electrode fingers are arranged opposite to each other, with a second gap between the second electrode fingers and the first dummy electrode fingers. The first busbar is parallel to the second busbar.

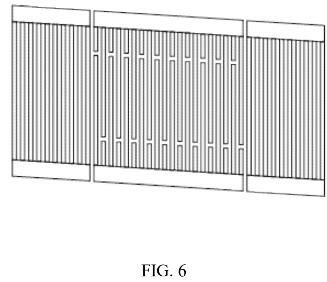

In one possible implementation, the first busbar and the second busbar may be parallel to a propagation direction of the elastic wave in the IDT electrode 130, with the electrode fingers perpendicular to the busbars. In another possible embodiment, the first busbar and the second busbar may form a preset angle with the propagation direction, respectively, while each electrode finger is perpendicular to the propagation direction. Additionally, a line connecting the first gap and the propagation direction, as well as a line connecting the second gap and the propagation direction, may also form a preset angle. Here, the preset angle is an angle within the range of (0, 90) degrees. Please refer to FIG. 6, which illustrates a schematic diagram of another possible IDT electrode 130. The present application does not limit this.

In summary, by providing the elastic wave device, which includes: the substrate, the piezoelectric layer arranged on the substrate, and the IDT electrode formed on the piezoelectric layer. The Euler angles of the substrate are (-45°±10°, -36°±10°, -45°±10°), or (-45°±10°, -36°±10°, -225°±10°). The Euler angles of the piezoelectric layer are (0°±10°, 130°±5°, 0°±10°), or (0°±10°, 140°±5°, 0°±10°). This configuration addresses the problem that parasitic acoustic modes generated in the conventional technologies affect an electrical performance of a device, thereby achieving the effect of suppressing the parasitic acoustic modes and improving electrical performance through a combination of the Euler angles of the substrate and the piezoelectric layer. The problem that a parasitic acoustic mode generated in the conventional technologies affect an electrical performance of a device is solved. The effect of suppressing the parasitic acoustic mode and improving the electrical performance may be achieved by a combination of the Euler angles of the substrate and the piezoelectric layer.

The present application further provides a filter, which includes the aforementioned elastic wave device.

The present application further provides a multiplexer, which includes the aforementioned elastic wave device.

The technical features of the above-mentioned embodiments can be combined arbitrarily. For the sake of brevity, not all possible combinations of the technical features in the above embodiments have been described. However, as long as there is no contradiction in the combination of these technical features, they should be considered within the scope of this specification.

The above-mentioned embodiments merely represent several implementations of the present invention, and the description is relatively specific and detailed, but it should not be construed as limiting the scope of the invention patent. It should be pointed out that for those skilled in the art, without departing from the concept of the present invention, several modifications and improvements can be made, all of which fall within the protection scope of the present invention. Therefore, the protection scope of the invention patent should be subject to the appended claims.

## Claims

1. An elastic wave device, **characterized by**, comprising:
a substrate;
a piezoelectric layer arranged on the substrate and an IDT electrode formed on the piezoelectric layer;
wherein Euler angles of the substrate are (-45°±10°, -36°±10°, -45°±10°), or (-45°±10°, -36°±10°, -225°±10°); and
Euler angles of the piezoelectric layer are (0°±10°, 130°±5°, 0°±10°), or (0°±10°, 140°±5°, 0°±10°).

2. The elastic wave device according to claim 1, **characterized in that** the Euler angles of the substrate are (-45°±5°, -36°±5°, -45°±5°), or (-45°±5°, -36°±5°, -225°±5°).

3. The elastic wave device according to claim 1 or 2, **characterized in that** the Euler angles of the piezoelectric layer are (0°±5°, 130°±4°, 0°±5°), or (0°±5°, 140°±3°, 0°±5°).

4. The elastic wave device according to claim 1, **characterized in that** the substrate comprises silicon, and the piezoelectric layer comprises at least one of LiTaO₃, LiNbO₃, ZnO, AlN, and PZT.

5. The surface acoustic wave device according to claim 1, **characterized in that** an intermediate layer is arranged between the substrate and the piezoelectric layer, wherein the intermediate layer comprises:
a high-acoustic-velocity film, arranged on the substrate, wherein an acoustic velocity of a bulk wave propagating in the high-acoustic-velocity film is higher than an acoustic velocity of an elastic wave propagating in the piezoelectric layer; and
a low-acoustic-velocity film, arranged on the high-acoustic-velocity film, wherein an acoustic velocity of a bulk wave propagating in the low-acoustic-velocity film is lower than the acoustic velocity of the elastic wave propagating in the piezoelectric layer.

6. The elastic wave device according to claim 1, **characterized in that** the substrate is a high-acoustic-velocity substrate with a high-acoustic-velocity film arranged on an upper layer of the substrate; and a low-acoustic-velocity film is arranged between the high-acoustic-velocity substrate and the piezoelectric layer;
wherein an acoustic velocity of a bulk wave propagating in the high-acoustic-velocity film is higher than an acoustic velocity of an elastic wave propagating in the piezoelectric layer, and an acoustic velocity of a bulk wave propagating in the low-acoustic-velocity film is lower than the acoustic velocity of the elastic wave propagating in the piezoelectric layer.

7. The elastic wave device according to claim 1, **characterized in that** a film thickness of the piezoelectric layer is greater than 0.1 λ, wherein λ is a wavelength determined based on a period of an electrode finger of the IDT electrode.

8. The elastic wave device according to claim 1, **characterized in that** the piezoelectric layer is LiTaO3, wherein a cut angle of the LiTaO3 is 30° or more and 60° or less.

9. A filter, **characterized by** comprising the elastic wave device according to any one of claims 1 to 8.

10. A multiplexer, **characterized by** comprising the elastic wave device according to any one of claims 1 to 8.
